**Europäisches Patentamt**

**European Patent Office**

**Office européen des brevets**

(19)

(11) Numéro de publication: **0 158 565**
**B1**

(12) **FASCICULE DE BREVET EUROPÉEN**

(45) Date de publication du fascicule du brevet:
**08.06.88**

(21) Numéro de dépôt: **85400624.4**

(22) Date de dépôt: **29.03.85**

(51) Int. Cl.⁴: **H 01 S 3/08**

(54) **Procédé de réalisation d'un miroir de laser à semi-conducteur, par usinage ionique.**

(30) Priorité: **03.04.84 FR 8405223**

(43) Date de publication de la demande:
**16.10.85 Bulletin 85/42**

(45) Mention de la délivrance du brevet:
**08.06.88 Bulletin 88/23**

(84) Etats contractants désignés:
**DE GB NL**

(56) Documents cité:
**EP-A-0 073 548**

**APPLIED PHYSICS LETTERS, vol. 37, no. 8, 15 octobre 1980, pages 681-683, American Institute of Physics, New York, US; L.A. COLDREN et al.: "GaInAsP/InP stripe-geometry laser with a reactive-ion-etched facet"**
**SOVIET JOURNAL OF QUANTUM ELECTRONICS, vol. 13, no. 4, avril 1983, pages 551-554, American Institute of Physics, New York, US; S.S. DEMIDOV et al.: "Bulk waveguide resonators for the ultraviolet part of the spectrum"**
**ELECTRONIS LETTERS, vol. 19, no. 6, mars 1983, pages 213-215, Londres, GB; O. MIKAMI et al.: "CW operation of 1.5 mum GaLnAsP/InP buried-heterostructure laser with a reactive-ion-etched facet"**

(73) Titulaire: **Bouadma, Noureddine, 45 A. Boulevard Jourdan, F-75014 Paris (FR)**

(72) Inventeur: **Bouadma, Noureddine, 45 A. Boulevard Jourdan, F-75014 Paris (FR)**

(74) Mandataire: **Mongrédien, André, c/o BREVATOME 25, rue de Ponthieu, F-75008 Paris (FR)**

## Description

La présente invention a pour objet un procédé de réalisation d'un miroir de laser à semiconducteur, par usinage ionique.

Le domaine technique de l'invention est celui des lasers à semiconducteurs dits à double hétérostructure et à géométrie en ruban. Une double hétérostructure est constituée d'un empilement de couches minces d'alliages semiconducteurs différents, ces couches étant déposées sur un substrat monocristallin, soit par épitaxie en phase liquide ou gazeuse, soit par jet moléculaire.

Pour permettre le fonctionnement en continu à température ambiante, la région active où sont confinés à la fois le rayonnement lumineux et les paires électron-trous, présente la forme d'un ruban dont la largeur est d'une dizaine de microns et la longueur comprise entre 100 et 300 µm. Cette longueur est celle qui sépare les deux faces clivées du cristal, faces qui forment les miroirs de la cavité résonante du laser.

Le domaine privilégié des lasers à semiconducteurs est celui des télécommunications optiques. Pour les lasers émettant entre 0,8 et 0,9 µm, les matériaux constituant les couches de la double hétérostructure sont pris dans la famille des solutions solides ternaires de formule générale $Ga_{1-x}Al_xAs$ où x est compris entre 0 et 1. Les couches sont épitaxiées sur un substrat en GaAs. Pour les longueurs d'ondes supérieures à 1 µm, les matériaux constituant les couches sont pris dans la famille des solutions solides quaternaires de formule générale $Ga_{1-x}In_xAs_{1-y}P_y$ où y est compris entre 0 et 1. Les couches sont épitaxiées sur un substrat en InP.

Dans le but de réaliser une intégration monolithique du laser et de fabriquer divers composants optiques et électroniques, des travaux ont été entrepris pour tenter de réaliser la cavité résonante du laser sans recours à la technique du clivage des faces du cristal. Différentes solutions ont été proposées, qui consistent soit à utiliser des réseaux de diffraction de haute résolution (lasers à réaction distribuée - dits DBF, ou à diffraction de Bragg distribuée, dit DBR), soit à usiner les faces réfléchissantes par attaque chimique ou par plasma réactif.

Cet art antérieur concernant la réalisation de miroirs par un procédé autre que le clivage des faces du cristal, a fait l'objet de nombreuses publications. On peut classer les diverses techniques connues en trois catégories

- celle où les miroirs du laser sont obtenus par attaque chimique humide ; c'est le cas des travaux publiés par J L. Merz et R.A. Logan dans "Journal of Applied Physics", vol. 47, page 3503, 1976, concernant les lasers en GaAs, et par K. Iga et B. I. Miller dans "IEEE Journal of Quantum Electronics", vol. QE-28, page 22, 1983 concernant les lasers en InP ;

- celle où les miroirs sont réalisés par attaque chimique sèche (RIE) ; c'est le cas des travaux publiés par L.A. Coldren et al dans "Applied Physics Letters", vol 37, page 681, 1980 et par O. Mikami dans "Electronics Letters", vol. 19, page 213, 1983 ;

- celle, enfin, où les miroirs sont réalisés par microclivage des faces, par creusement au moyen d'une attaque chimique sélective, d'un canal entre le substrat et la double hétérostructure et par application d'une pression ultrasonique ou manuelle provoquant le clivage des différentes couches de la double hétérostructure, sans qu'il y ait clivage du substrat ; cette technique a été décrite notamment par H. Blauvelt et al dans "Applied Physics Letters", vol. 40, page 289, 1981.

Ces techniques antérieures présentent toutes des inconvénients.

La technique utilisant l'attaque chimique humide conduit généralement à la formation de plans qui n'ont pas l'orientation requise mais sont inclinés par rapport à celle-ci de quelques degrés. Il en résulte une augmentation sensible du courant de seuil (50 à 100 %). Par ailleurs, les résultats obtenus sont peut reproductibles et dépendent largement du masque utilisé.

L'attaque chimique réactive sèche (RIE), qui agit à la fois par enlèvement chimique et par enlèvement physique du matériau à graver, entaîne des effets de redéposition et de contamination rendant tes surfaces gravées rugueuses et non planes. En outre, le profil des parois gravées dépend de plusieurs paramètres (composition et pression du gaz réactif utilisé, épaisseur et caractéristiques du matériau de masquage), ce qui donne au résultat obtenu un caractère aléatoire.

Quant à la technique utilisant le microclivage, elle pose le problème de l'intégration du laser avec une photodiode de réaction située sur le même substrat. L'efficacité du couplage entre le laser et la photodiode dépend essentiellement de la distance entre ces deux, composants. Or, la distance minimale obtenue jusqu'à présent est prohibitive (environ 140 µm). Le signal détecté par la photodiode est alors très faible (inférieur à 5 µA/mW).

Le but de l'invention est de surmonter les difficultés recontrées dans ces différentes techniques. A cette fin, l'invention préconise l'utilisation de l'usinage ionique pour la réalisation d'un ou des miroirs du laser, et ceci dans des conditions de masquage particulières.

L'usinage ionique est une technique de gravure utilisée largement dans la réalisation des dispositifs électroniques actuels (circuits intégrés). Il s'agit d'une gravure par voie sèche au moyen d'ions (d'argon par exemple) accélérés par un champ électrique dans un canon à ions, notamment du type KAUFMAN. Ces ions accélérés tombent sur une cible d'où ils chassent les atomes par un mécanisme de transfert de quantité de mouvement.

L'usinage ionique présente une caractéristique essentielle qui est la directivité du faisceau d'ions utilisé. Cette directivité permet de commander avec précision la pente de la paroi gravée. L'intérêt de l'usinage ionique pour réaliser des miroirs de laser a été décrit par le demandeur lors de la Conférence intitulée "Second European Conference on Integrated Optics" qui s'est tenue à Florence (Italie) les 17 et 18 Octobre 1983 (Conference Publication n°227, pages 24-26).

La présente invention porte sur les conditions de mise en oeuvre de cette technique et a pour but d'améliorer la qualité des miroirs obtenus. Le perfectionnement apporté par la présente invention concerne principalement l'étape de masquage intervenant lors de l'opération de bombardement ionique.

L'utilisation des matériaux habituels en matière de masque (résine photosensible, dioxyde de silicizium, titane) s'est révélée peu satisfaisante pour un usinage ionique profond (de l'ordre de 4-5 μm). Dans tous les cas, les faces obtenues sont rugueuses et leur planéité médiocre. Le demandeur a trouvé que l'origine de ces défauts tenait à la mauvaise définition du masque utilisé. Pour résoudre ce problème, le demandeur propose alors d'utiliser, comme masque, une couche de matériau cristallin opaque au faisceau d'ions, cette couche étant délimitée latéralement par au moins une face constituant le flanc du masque, cette face étant un plan cristallographique du matériau utilisé. De cette manière, le flanc du masque est parfaitement défini et l'opération d'usinage ionique, qui s'effectue à travers ce masque, conduit à une gravure parfaite la face gravée est lisse et plane.

De façon précise, l'invention a donc pour objet un procédé de réalisation d'un miroir de laser à semiconducteurs par usinage ionique, dans lequel on soumet une structure semiconductrice à un bombardement ionique à travers un masque dont un flanc détermine l'emplacement du miroir à usiner, ce procédé étant caractérisé par le fait que ce masque est constitué par une couche cristalline dont le flanc est un plan cristallographique.

Selon une première variante, le masque est obtenu par épitaxie d'une couche cristalline sur la structure semiconductrice, puis par attaque chimique de cette couche pour former le plan cristallographique.

Selon une seconde variante, le masque est constitué par une barrette mince à faces clivées posée et de préférence collée sur la structure semiconductrice.

Selon une autre variante le bombardement ionique s'effectue selon une direction inclinée par rapport au plan perpendiculaire à la structure semiconductrice. Il a été observé, en effet, par le demandeur, qu'avec une incidence normale, on obtenait un plan de gravure légèrement incliné par rapport au plan normal à la structure (angle de l'ordre de 27°). En augmentant l'angle d'incidence du faisceau par rapport à la normale, l'obliquité de la face usinée diminue. L'inclinaison du faisceau d'ions incident par rapport à l'échantillon à usiner peut être effectuée de deux façons différentes soit en inclinant directement le porte-substrat tournant sur lequel est posé l'échantillon, soit en posant l'échantillon sur une cale faisant un angle α avec le porte-substrat qui reste, lui, horizontal. Une face parfaitement verticale peut être obtenue pour un angle d'incidence voisin de 230 en utilisant la première technique et 12° en utilisant la deuxième technique.

De toutes façons, les caractéristiques de l'invention apparaîtront mieux après la description qui suit, d'exemples de réalisation donnés à titre explicatif et nullement limitatif. Cette description se réfère à des dessins annexés sur lesquels :

la figure 1 illustre une première variante du procédé, utilisant, comme masque, une couche épitaxiée à plan cristallographique obtenu par attaque chimique,

- les figures 2a, 2b et 2c illustrent une variante dans laquelle le masque utilisé est constitué par une mince barrette à faces clivées collée sur la structure à graver,

- les figures 3a à 3f illustrent diverses étapes d'un procédé de réalisation d'un laser à cavité courte obtenu uniquement par usinage ionique,

- les figures 4a à 4g illustrent diverses étapes d'un procédé de réalisation d'un laser à cavité courte obtenu par emploi combiné d'un usinage ionique et d'une attaque chimique,

- la figure 5 illustre un masque en vue de dessus permettant d'obtenir un laser à une face décapée et une face clivée,

- la figure 6 illustre un dispositif à laser et à photodétecteur intégrés sur un même substrat,

- la figure 7 montre un détail, vu en coupe, du dispositif précèdent,

- la figure 8 illustre un laser multimode longitudinal à miroirs inclinés par rapport au ruban, la figure 9 illustre un laser monofréquence formé de deux cavités couplées intégrées sur un même substrat.

Dans la description qui suit, la structure de base constituant le laser ne sera pas décrite en détail car elle est largement connue. Il suffit de rappeler qu'il s'agit d'une double hétérostructure comprenant généralement une première couche de confinement, une couche active, une seconde couche de confinement, une couche de contact et une couche métallique. Les couches semiconductrices subissent un bombardement protonique destiné à délimiter un ruban actif.

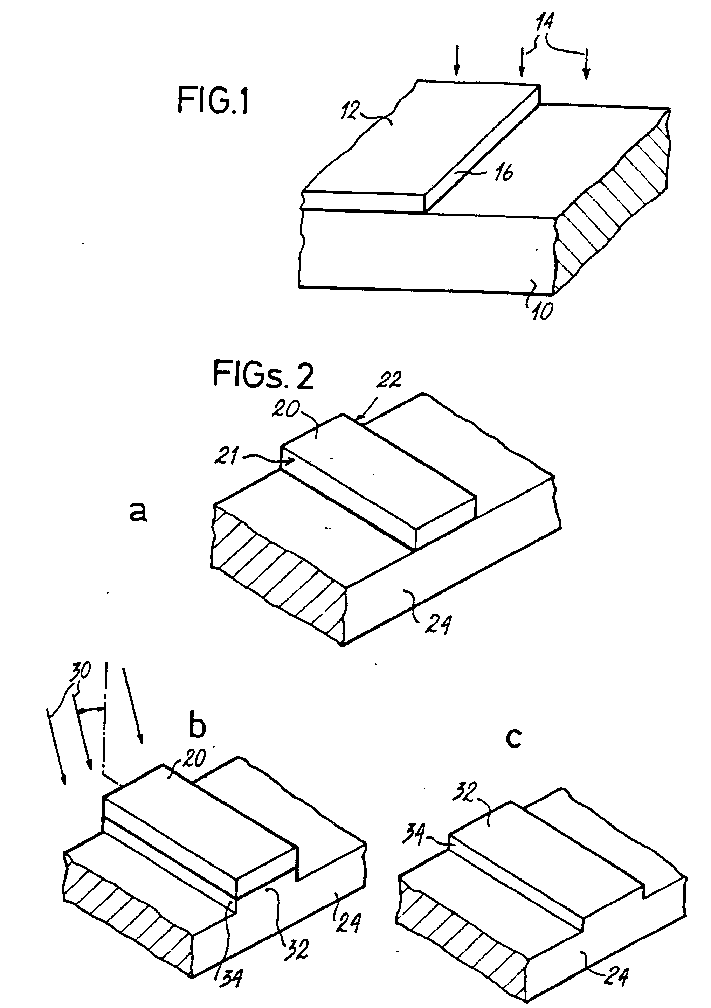

La figure 1 montre une telle hétérostructure 10 sur laquelle a été déposée une couche épitaxiée 12 servant de masque pour une opération de gravure symbolisée par les flèches 14. Selon l'une des caractéristiques essentielles de l'invention, la couche épitaxiée 12 présente un flanc 16 qui est un plan cristallographique pour le cristal constituant la couche 12. Ce plan est obtenu par attaque chimique de la couche 12. Cette attaque chimique s'effectue de manière classique en protégeant la couche épitaxiée 12 par un masque dont le bord définit le flanc 16.

La figure 2a illustre une autre variante dans

0 158 565

laquelle le masque est une mince barrette 20, clivée le long de deux faces 21, 22 et collée sur une hétérostructure 24. La barrette peut être en GaAs par exemple et les plans cristallographiques de clivage peuvent correspondre, par exemple, aux orientations cristallines (110) ou (110).

La figure 2b illustre l'étape d'usinage ionique avec un faisceau d'ions 30 dont la direction fait un angle a avec la normale à la structure. Cet angle peut être d'une vingtaine de degrés. On obtient alors une marche 32 dont le flanc 34 est vertical et parfaitement lisse et plan.

La figure 2c illustre la mésa 32 obtenue après élimination du masque 20. La face 34 constitue la face réfléchissante formant miroir.

Le procédé de fabrication qui vient d'être décrit permet la réalisation de structures qui ne peuvent être que très difficilement obtenues par les procédés de clivage classiques. Trois exemples de ces structures vont être décrits, concernant respective ment un laser à cavité courte, une structure à laser et photodétecteur ou laser et guide optique intégrés sur un même substrat et un laser multimode longitudinal intégré.

Il est connu que certaines propriétés des lasers sont étroitement liées à la longueur de la cavité. C'est le cas notamment du courant de seuil, du rendement quantique externe, de l'espacement entre modes longitudinaux, de la fréquence de modulation, etc... En général, ces propriétés sont d'autant meilleures que la longueur de la cavité est faible. D'où l'intérêt des lasers courts. Cependant, en raison même de leurs dimensions réduites, une difficulté surgit lors du montage de ces lasers sur des dissipateurs thermiques et lors de la réalisation des connexions électriques.

Le procédé de l'invention permet d'éviter ces difficultés comme on va le voir sur les deux exemples suivants.

a - Laser court réalisé sans attaque chimique.

Un tel laser peut être réalisé à l'aide d'une double hétérostructure GaAlAs sur GaAs ou GaInAsP sur InP.

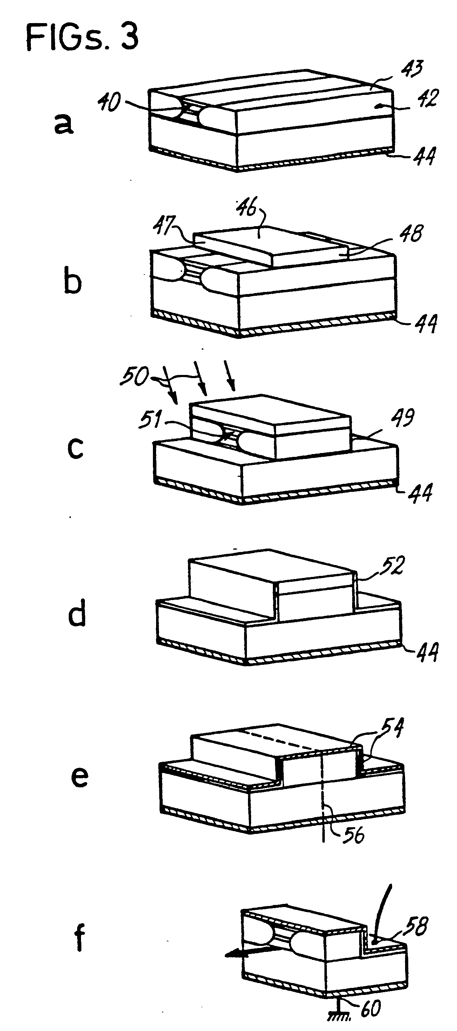

Les différentes opérations technologiques conduisant à un tel laser sont décrites sur les figures 3a à 3f qui illustrent respectivement :

Figure 3a : la réalisation d'une structure en ruban 40 sur une double hétérostructure 42 et de contacts ohmiques sur les deux faces 43 et 44 ;

Figure 3b : le masquage par une barrette 46 en GaAs à deux faces clivées 47 et 48 ;

Figure 3c : l'usinage ionique par un faisceau d'ions d'argon 50 de 23° d'angle d'incidence ; l'échantillon étant directement posé sur le porte-substrat incliné et tournant, c'est au cours de cette étape que sont formées les deux faces réfléchissantes 49 et 51 ;

Figure 3d : le dépôt d'une couche de diélectrique 52 d'épaisseur λ̸ où λ est la longueur d'onde de fonctionnement du laser ;

Figure 3e : le retrait du masque et le dépôt d'une couche métallique (d'or par exemple) 54 sur toute la surface ;

Figure 3f : enfin, le clivage de la structure le long du plan 56 pour former deux lasers, et la prise des contacts 58 et 60. La cavité du laser possède une face clivée (selon l'art antérieur) et une face usinée (selon l'invention).

On observera que, du fait de la forme en escalier de la structure obtenue, le problème de prise de contact sur le laser ne se pose pas, vu la possibilité de prendre ce contact sur la partie du substrat couverte d'or.

Comme la vitesse d'attaque ionique de GaAs est plus faible que celle de GaAlAs, la barrette 46 formant le masque est constituée d'une couche fine de $Ga_xAl_{1-x}As$ avec x supérieur à environ 0,5 épitaxiée sur le substrat.

Des essais effectués par le demandeur ont permis d'obtenir des lasers à une face clivée et une face usinée pour lesquels les courants de seuil mesurés étaient typiquement de 120 mA pour des rubans de 12 µm de large et des longueurs de cavité de 380 µm et de 18 mA pour des rubans enterrés de 5,5 µm de large et des longueurs de cavité de 60 µm. Ces valeurs de courant de seuil sont équivalentes à celles qui sont obtenues avec des lasers de même longueur et à deux faces clivées.

b - Laser court réalisé par une combinaison usinage ionique-attaque chimique.

Un tel laser ne peut être réalisé qu'à l'aide d'une double hétérostructure GaInAsP sur InP car InP présente des propriétés d'attaque chimique différentes de celles des autres matériaux III-V. En effet, il existe des solutions chimiques telles que l'acide chlorhydrique pur (HCl) ou le mélange acide chlorhydrique-acide orthophosphorique ($HCl-H_3PO_4$), pour lesquelles certains plans cristallographiques de InP présentent des vitesses d'attaque très faibles par rapport aux autres plans. Cette différence dans les vitesses d'attaque a pour conséquence de faire apparaître les plans pour lesquels les vitesses sont les plus faibles. Ces plans forment ainsi les profils des mésas obtenues.

Dans le cas de InP, les plans (110) et (110) sont perpendiculaires aux plans (001) du substrat et présentent une vitesse d'attaque quasi-nulle. Après attaque chimique dans une solution de HCl pur, des mésas rectangulaires avec des bords droits peuvent alors être formées. Cependant, aucune autre solution n'a montré d'effets analogues sur GaAs ou sur GaInAsP.

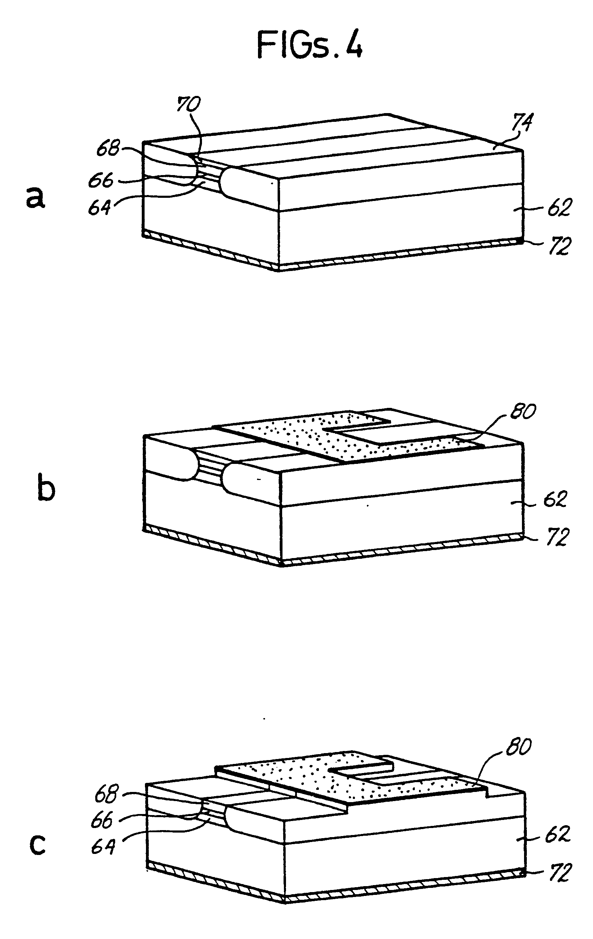

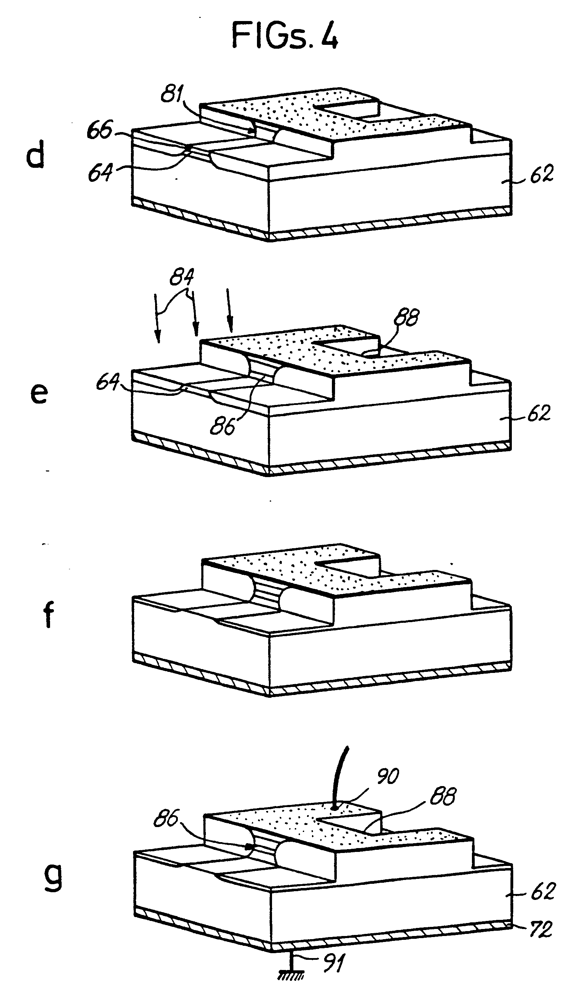

Dans le cas d'une double hétérostructure, un usinage ionique des couches en GaInAsP suivi d'une attaque chimique des couches en InP par des solutions de HCl ou de $HCl-H_3PO_4$, entraîne la formation de faces réfléchissantes planes, lisses et verticales. Les différentes opérations sont décrites sur les figures 4a à 4g :

Figure 4a : définition d'une double hétérostructure GaInAsP sur InP avec un substrat 62 en InP, une première couche de confinement 64 en InP de type n, une couche active 66 en GaInAsP, une seconde couche de confinement 68 en InP de type p, et une couche de contact 70 en GaInAs ou GaInAsP de type P. La structure se complète par des métallisations 72 et 74 formant contacts ohmiques après avoir réalisé le ruban laser (par bombardement ou par enterrement) ;

Figure 4b : définition d'un masque 80 en résine ou en diélectrique (Al₂O₃) en forme de "U", sur la surface de la double hétérostructure ; ce type de masque peut convenir pour cette étape car la profondeur de l'attaque est faible (inférieure à 0,5 µm) ;

Figure 4c : attaque ionique de la couche métallique supérieure 74 et de la couche de contact 70 en GaInAsp, jusqu'à la deuxième couche de confinement 68 en InP ;

Figure 4d : attaque chimique de la deuxième couche de confinement 68 en InP, par une solution de HCl concentré ou une solution HCl-H₃PO₄ ; ces solutions n'attaquent pas GaInAsp ; c'est cette attaque chimique qui forme le plan cristallographique 81, dans la seconde couche de confinement 68 en InP ;

Figure 4e : usinage ionique de la couche active 66 en GaInAsP par un faisceau d'ions d'argon 84 d'incidence 23° ; le plan cristallographique parfait formé dans la seconde couche de confinement en InP sert de masque pour cet usinage, comme décrit à propos de la figure 1 ; cet usinage ionique forme les deux faces réfléchissantes 86 et 88 du laser ,

Figure 4f : attaque chimique sélective de la première couche de confinement 64, de la même manière que pour la seconde couche de confinement 68, puis légère attaque chimique durant 5 à 10 secondes de toutes les couches de la double hétérostructure par une solution non sélective formée d'un mélange brome-méthanol à 5%o ;

Figure 4g : retrait du masque en résine 80, prise de contacts 90, 91 et montage, le côté p étant disposé sur le dessus.

Dans cette variante du procédé, le laser obtenu présente deux faces réfléchissantes 86, 88 obtenues par usinage ionique.

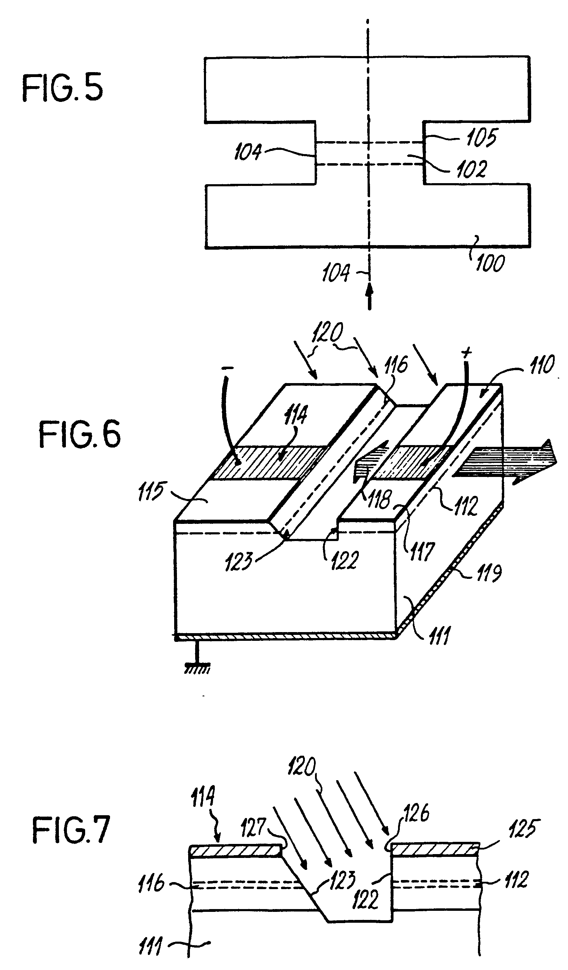

Cette structure pose le problème délicat de son raccordement à une fibre optique. En effet, comme le bord du laser (qui est au niveau de la couche active 66) ne coïncide pas avec le bord du substrat 62, il est difficile de mettre une fibre optique de quelques dizaines de microns de diamètre en contact immédiat avec le laser. Pour cette raison, on peut préférer une structure à seulement une face décapée par usinage ionique, l'autre face étant clivée. Les étapes de réalisation sont identiques à celles du laser décrit plus haut, si ne c'est qu'au lieu d'utiliser un masque en forme de U, on utilise un masque en forme de H. Ce masque est représenté en vue de dessus sur la figure 5. Il porte la référence 100. Le ruban actif porte la référence 102. Après que les opérations illustrées sur les figures 4a à 4g ont été réalisées, la structure est clivée en son milieu, le long d'un plan de clivage 104. La place de ce plan par rapport aux deux faces 104 et 105 obtenues par usinage ionique, détermine les longueurs respectives des cavités des deux lasers.

Le procédé de l'invention permet aussi de réaliser des structures plus complexes que celles qui viennent d'être décrites. Il s'agit de structures comprenant non seulement un laser mais encore un guide optique ou un photodétecteur (par exemple une photodiode). Celui-ci est inclus dans une boucle de contre-réaction servant à régler le courant d'alimentation du laser en fonction de la puissance détectée.

Un tel dispositif est représenté sur la figure 6. Il comprend un laser formé d'une double hétérostructure 110 déposée sur un substrat 111, cette hétérostructure comprenant notamment une couche active 112. En regard de ce laser, une autre hétérostructure 114 fonctionne en photodétecteur ; elle possède une couche active 116 située dans le plan de la couche 120 et qui reçoit une partie 118 du rayonnement émis par le laser. L'ensemble comporte encore des contacts ohmiques 115, 117 et 119.

Le sillon séparant le laser 110 et le photodétecteur 114 est obtenu dans le cas d'une double hétérostructure en InP, par le procédé de l'invention, c'est-à-dire par usinage ionique à travers un masque à flanc cristallographique. Le masque est percé d'une ouverture correspondant au sillon à graver. Comme on utilise un faisceau d'ions 120 incliné par rapport à la normale (pour obtenir, comme expliqué plus haut, une face réfléchissante 122 perpendiculaire au plan des couches de l'hétérostructure) on obtient, du côté de la photodiode, une face gravée 123 qui est sensiblement inclinée par rapport au plan normal. Loin d'être un défaut, cette disposition permet de supprimer tout risque de contre-réaction dû à une réflexion du faisceau 118 sur la face 123 avec réinjection dans le laser 110.

La réalisation du sillon par usinage ionique permet d'obtenir une largeur très faible de l'ordre de 10 µm, ce qui renforce le couplage entre le laser 110 et la photodiode 114.

La figure 7 montre, en coupe, les éléments précédents pendant l'opération d'usinage ionique. On retrouve, sur le substrat 111, le laser 110, la photodiode 114, le faisceau d'ions 120, la face réfléchis sante 122 perpendiculaire au plan de la structure et la face inclinée 123. Le masque 125 possède des flancs 126 et 127 qui sont, selon la caractéristique essentielle de l'invention, des plans cristallographiques.

Les lasers en ruban à guidage par l'indice, ont permis une amélioration des performances des lasers par rapport aux structures à guidage par le gain (diminution de courant de seuil, amélioration de la linéarité puissance-courant, de la stabilité des modes et surtout possibilité de fonctionner sur un seul mode longitudinal). Cependant, il est connu qu'un laser monomode longitudinal ne convient pas comme source de lumière pour les transmissions par fibres multimodes. Un fonctionnement multimode longitudinal est préférable. Un tel fonctionnement peut être obtenu dans des structures à guidage par l'indice, à condition d'incliner le ruban par rapport à la direction perpendiculaire au plan des faces clivées.

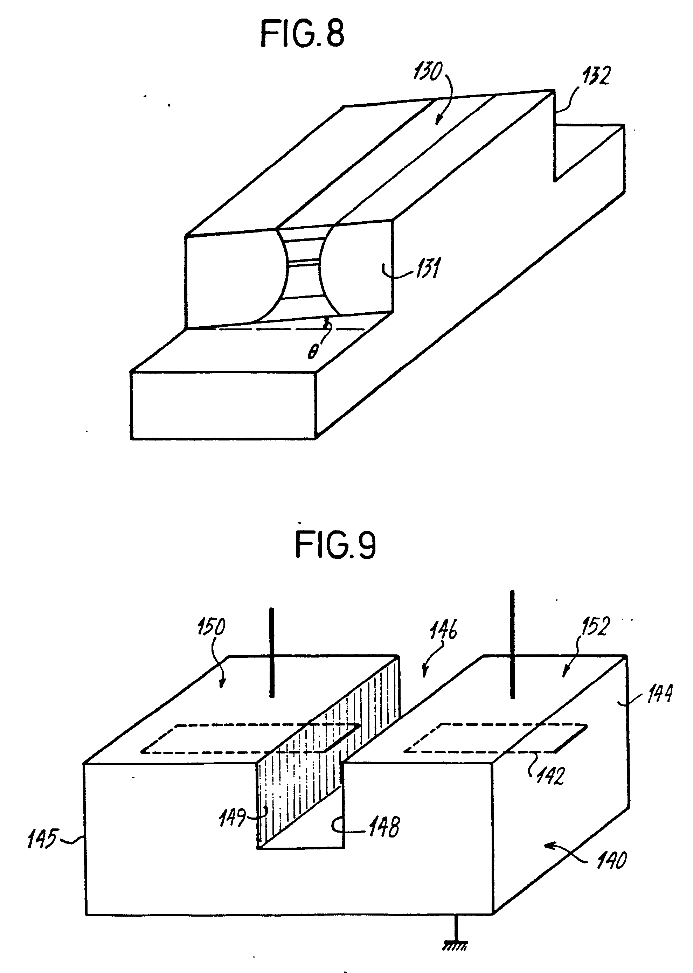

Cette disposition peut être facilement obtenue par usinage des deux faces du laser suivant deux directions parallèles entre elles mais faisant un angle de quelques degrés par rapport à la direction du ruban. C'est ce qui est illustré sur la figure 8 où l'on voit une structure 130 du type à ruban enterré, limitée par des faces 131, 132, inclinées d'un dangle Ø par rapport au plan perpendiculaire à la direction du ruban.

Malgré les réserves formulées plus haut sur le fonctionnement en mode longitudinal unique, ce type de régime reste d'une grande importance pour les systèmes de communications à haut débit. Mais il faut alors stabiliser le spectre du laser. Pour cela plusieurs solutions ont été proposées lasers courts, lasers à réaction distribuée, lasers à réseau distribué, etc...

Dans un article intitulé "High-speed direct single-frequency modulation with large tuning rate and frequency excursion in cleaved-coupled-cavity semiconductor lasers" publié dans la revue "Applied Physics Letters" 42(8), 15 avril 1983, par W.T. TSANG et al, il est décrit un dispositif formé de deux diodes lasers clivées et couplées optiquement par alignement de leurs rubans actifs. Les longueurs des deux cavités sont sensiblement égales (200-400 µm) et la distance les séparant est inférieure à 5 µm.

Dans un tel dispositif, l'une des deux diodes fonctionne en laser, l'autre en modulateur de fréquence, ce qui permet de stabiliser le mode d'oscillation. Un tel dispositif a permis d'obtenir des spectres monomodes longitudinaux stables, même à des fréquences de modulation élevées.

Cependant, ces dispositifs posent le problème délicat de leur positionnement l'un par rapport à l'autre à une distance inférieure à 5 µm, ainsi que celui de l'alignement des deux cavités.

La figure 9 montre un dispositif de ce type, obtenu par un procédé de réalisation très simple qui fait appel à la technique de l'invention décrite plus haut. On part d'une hétérostructure 140 possédant un ruban actif 142, et limitée par deux faces clivées 144 et 145. Sur cette structure on pose un masque ayant une ouverture d'environ 5 µm, cette ouverture étant perpendiculaire à la direction du ruban actif. Les flancs de ce masque sont des plans cristallographiques. A travers l'ouverture du masque, on effectue un usinage ionique qui a pour effet de creuser un sillon 146 délimité par deux faces 148, 149. D'un côté, on obtient un laser émetteur 150 et de l'autre un dispositif modulateur 152. Les deux dispositifs se trouvent intégrés sur le même support.

Le procédé d'usinage qui vient d'être décrit à l'aidé de ces différents exemples, est essentiellement basé sur un enlèvement de matière par bombardement ionique. Lors du choc élastique des ions avec les atomes de la cible, les ions incidents transfèrent des quantités de mouvement importantes aux atomes du réseau cristallin et provoquent ainsi leur arrachage. Mais ces chocs induisent également des défauts cristallins. Le degré de perturbation de la surface bombardée dépend de la tension d'accélération des ions plus cette tension est faible moins les défauts créés sont importants. Mais la vitesse de gravure décroît avec la tension. Un compromis doit donc être trouvé pour obtenir une vitesse de gravure satisfaisante tout en limitant la perturbation de la surface usinée.

La photoluminescence des matériaux bombardés étant sensible aux défauts cristallins, une étude des variations de l'intensité de cette luminescence permet de suivre l'évolution du nombre des défauts. Le demandeur a montré qu'une première gravure peut être réalisée avec une tension de 500 Volts et une densité de courant d'ions de 0,5 mA/cm$^2$ durant une heure, suivie immédiatement d'une seconde gravure à une tension de 300 Volts et une densité d'ions de 0,2 mA/cm$^2$ durant quelques dizaines de minutes.

Pour des tensions d'accélération inférieure à 300 Volts, la divergence du faisceau d'ions augmenterait, ce qui altèrerait la directivité de l'usinage.

La première gravure à forte tension d'accélération et à forte pression d'argon, permet d'atteindre une profondeur d'environ 5 µm, ce qui correspond généralement à l'épaisseur totale des couches d'une double hétérostructure classique. La deuxième gravure, à faible tension d'accélération et à faible pression d'argon, permet de décaper la surface obtenue après la première attaque en créant une surface faiblement perturbée.

On peut définitivement éliminer les défauts résiduels par immersion de l'échantillon durant quelques secondes dans une solution chimique composée de 1 volume de H$_2$SO$_4$, 8 volumes de H$_2$O$_2$ et 1 volume de H$_2$O à 0°C, dans le cas de GaAs ou dans un mélange de bromeméthanol à 5‰ dans le cas InP.

**Revendications**

1. Procédé de réalisation d'un miroir de laser à semiconducteurs par usinage ionique dans lequel on soumet une structure semiconductrice (10) à un bombardement ionique (14) à travers un masque dont un flanc détermine l'emplacement de ce miroir, caractérisé par le fait que ce masque est constitué par une couche cristalline (12) dont le flanc (16) est un plan cristallographique.

2. Procédé selon la revendication 1, caractérisé par le fait qu'on réalise le masque par épitaxie d'une couche cristalline (12) sur la structure semiconductrice (10), puis par attaque chimique de cette couche le long d'un plan cristallographique (16).

3. Procédé selon la revendication 1, caractérisé par le fait qu'on réalise le masque en collant une barrette mince faces (20) clivées (21, 22) sur la structure, semiconductrice (24).

4. Procédé selon la revendication 1, caractérisé par le fait que le bombardement ionique (30) s'effectue selon une direction qui est inclinée par rapport au plan perpendiculaire à la structure semiconductrice (24), cette inclinaison pouvant être obtenue soit en inclinant le porte-substrat tournant, soit en posant l'échantillon sur une cale d'angle a et en gardant le porte-substrat horizontal.

**Patentansprüche**

1. Verfahren zur Herstellung eines Halbleiterlaserspiegels durch ionische Bearbeitung, bei der man eine Halbleiterstruktur (10) einem Ionenbeschuß (14) durch eine Maske hindurch aussetzt, von der eine Flanke die Lage dieses Spiegels festlegt, dadurch gekennzeichnet, daß diese Maske von einer kristallinen Schicht (12) gebildet wird, deren Flanke (16) eine kristallographische Ebene ist.

2. Verfahren nach Anspruch 1, dadurch gekennzeichnet, daß man die Maske durch Aufwachsen einer kristallinen Schicht (12) auf der Halbleiterstruktur (10) und dann durch chemischen Einfluß auf diese Schicht längs einer kristallographischen Ebene (16) herstellt.

3. Verfahren nach Anspruch 1, dadurch gekennzeichnet, daß man die Maske durch Aufkleben eines dünnen Steges (20), der gespaltene Seiten (21, 22) aufweist, auf die Halbleiterstruktur (24) herstellt.

4. Verfahren nach Anspruch 1, dadurch gekennzeichnet, daß der Ionenbeschuß (30) in einer Richtung erfolgt, die in Bezug auf die zu der Halbleiterstruktur (24) senkrechte Ebene geneigt ist, wobei diese Neigung entweder dadurch erhalten werden kann, daß der drehbare Substratträger geneigt wird oder daß die Probe auf einem Keil mit dem Winkel α angeordnet und der Substratträger horizontal gehalten wird.

**Claims**

1. Process for producing a semiconductor laser mirror by ionic machining in which a semiconductor structure (10) undergoes an ionic bombardment (14) through a mask, whereof one side determines the location of said mirror, characterized in that this mask is constituted by a crystalline layer (12), whereof the side (16) is a crystallographic plane.

2. Process according to claim 1, characterized in that the mask is produced by the epitaxy of a crystalline layer (12) on the semiconductor structure (10), then by chemically etching said layer along a crystallographic plane (16).

3. Process according to claim 1, characterized in that the mask is produced by bonding a thin strip (20) with cleaved faces (21, 22) to the semiconductor structure (24).

4. Process according to claim 1, characterized in that ionic bombardment (30) takes place in a direction which is inclined with respect to the plane perpendicular to the semiconductor structure (24), said inclination being obtainable either by inclining the rotary substrate holder, or by placing the sample on a shim of angle α and whilst keeping the substrate holder horizontal.

0 158 565

FIG.1

FIGs. 2

a

b

c

# FIGs. 3

a

b

c

d

e

f

# FIGs.4

# FIGs. 4

d

81
66
64
62

e

84
88
64
86
62

f

g

90
88
86
62
72
91

FIG.5

*104* — *105*
*102*

*104* ↑

*100*

FIG.6

*120* *116* *110*

*114*
*115*
*123* *118* *112*
*122* *117*
*119*
*111*

FIG.7

*120*

*114* *127* *126* *125*
*116* *123* *112*
*122*
*111*

0 158 565

# FIG.8

130
132
131
$\theta$

# FIG.9

150    146    152
144
142
145    149    148    140